# FASCICULE DE BREVET EUROPEEN

(11) **EP 2 273 679 B1**
(45) Date de publication et mention de la délivrance du brevet: **12.08.2015**
(21) Numéro de dépôt: 10168564.2
(22) Date de dépôt: 06.07.2010
(51) Int. Cl.: H03K 17/96, H01M 2/02

(54) **Emetteur domotique de type point de commande et de type sensitif à détection capacitive**
Heimsender vom Typ Steuerpunkt und vom Sensortyp für die kapazitive Erkennung
Home-automation transmitter of the control point type and sensitive type with capacitive detection

(30) Priorité: 07.07.2009 FR 0954703
(43) Date de publication de la demande: 12.01.2011
(73) Titulaire: Somfy SAS, 74300 Cluses (FR)
(72) Inventeur: Gigout, Fabrice, 74190 PASSY (FR); Deshayes, Jean-Christophe, 74800 SAINT-PIERRE-EN-FAUCIGNY (FR); Mathieu, Jérôme, 74960 CRAN-GEVRIER (FR)
(74) Mandataire: Novaimo

(56) Documents cités:
- EP-A1- 0 079 410
- EP-A1- 1 079 325
- DE-A1-102004 026 672
- US-A- 5 410 148
- US-A1- 2005 146 510

## Description

L'invention concerne un émetteur domotique destiné à la commande distante par radiofréquences des actionneurs contrôlant une charge électrique dans un bâtiment, cette charge électrique étant destinée au confort thermique, visuel ou lumineux, à la protection solaire, à la fermeture ou à la sécurité du bâtiment ou de ses abords. L'invention concerne également un procédé de fonctionnement d'un tel émetteur et un procédé de configuration d'un tel émetteur.

Un tel émetteur est de type point de commande mural, c'est-à-dire qu'il est destiné à être posé sur un mur, de la même façon qu'un interrupteur mural d'appareillage électrique. Mais contrairement à ce dernier, l'émetteur n'est pas raccordé à des fils électriques de l'installation électrique du bâtiment et ne nécessite pas de boîte d'encastrement logée à l'intérieur du mur. L'émetteur contient en effet un émetteur radiofréquences et il est alimenté par une pile.

Alternativement, l'émetteur est de type point de commande nomade.

L'émetteur est également de type sensitif, à détection capacitive. Des points de commande à détection capacitive sont connus de l'art antérieur. Ils permettent en particulier d'émettre des ordres d'activation de commandes lorsque le doigt de l'utilisateur s'approche ou se pose sur une plaque isolante extérieure, par exemple en verre, masquant un jeu d'électrodes dont la capacité varie en présence du doigt. Le principe de fonctionnement et différents modes de réalisation sont décrits par exemple dans les demandes de brevet GB 2 279 750, DE 10 2004 026 672, US 2008/0197909 et US 2009/0090605, pour différents types d'application et notamment des plaques de cuisson.

On connaît aussi du document EP 1 079 325 une montre comprenant des capteurs capacitifs utilisés pour commander les mouvements d'un curseur sur un écran d'ordinateur.

On connaît encore du document US 5 410 148 un capteur de sécurité à moyens optiques et capacitifs.

On connaît enfin du document EP 0 079 410 un programmateur de chauffage.

Un problème dimensionnel se pose dans le cas d'un émetteur à détection capacitive destiné à servir de point de commande mural : pour avoir des dimensions semblables aux dimensions apparentes d'un interrupteur mural traditionnel, il importe que l'épaisseur de l'émetteur soit très faible, par exemple de l'ordre de 10 mm. De plus, l'émetteur doit pouvoir s'intégrer à l'intérieur d'un cadre de décoration et de protection du mur contre les salissures des doigts. Une dimension normalisée de logements internes à ces cadres est un carré de 50 mm de côté. Le volume disponible est donc très réduit. Ce problème dimensionnel, et l'autonomie nécessaire à plusieurs années de fonctionnement, obligent à une alimentation par pile bouton (ou pile pièce de monnaie en langue anglaise) de grand diamètre, par exemple une pile lithium de type LM 2430 ou CR 2430. Une telle pile bouton présente un diamètre de 24 mm et une épaisseur de 30 dixièmes de millimètre.

On trouve les mêmes contraintes dimensionnelles dans un point de commande de type nomade si des raisons esthétiques conduisent à lui donner une forme très compacte.

Il en résulte que la zone affectée à la pile sur le circuit imprimé supportant les électrodes capacitives recouvre, au moins partiellement et éventuellement en totalité ces électrodes.

De ce fait, un installateur mettant en place la pile peut provoquer l'émission de commandes involontaires : d'une part, parce que les composants électroniques deviennent sous tension pendant l'insertion de la pile et que les mouvements de la pile provoquent des variations importantes de la capacité vue par les différentes électrodes ; et, d'autre part, parce que la pile participe à son tour au système de détection capacitive et qu'un effleurement de la pile sans même la déplacer peut provoquer l'émission d'une commande involontaire.

La première mise en place de la pile peut être assurée par le fabricant, ce qui évite à l'installateur l'émission d'ordres intempestifs lors de l'insertion. Mais il reste cependant un risque de provoquer un mouvement de la pile dans son logement, ou un simple effleurement de celle-ci, lors d'une opération d'appairage de l'émetteur avec un actionneur. En effet, il existe en général sur la face arrière de l'émetteur (non accessible à un usager) un bouton agissant sur un contact de mise en mode d'appairage. En manipulant l'émetteur pour appuyer sur ce bouton, l'installateur risque de provoquer l'émission intempestive d'ordres vers d'autres actionneurs déjà appairés à l'émetteur.

Ce type de commande intempestive pendant une opération d'appairage est beaucoup moins compréhensible qu'une commande intempestive pendant une opération de changement de pile, et donc plus grave en terme de ressenti sur la qualité du produit.

Le but de l'invention est de fournir un émetteur remédiant aux inconvénients ci-dessus et améliorant les émetteurs connus de l'art antérieur. En particulier, l'invention permet de réaliser un émetteur simple, compact, de faible épaisseur, économique et permettant d'éviter les émissions intempestives lors d'une opération d'appairage.

L'émetteur domotique selon l'invention est de type point de commande et de type sensitif à détection capacitive et comprend :
- une plaque extérieure isolante sous laquelle est disposée une face avant d'un circuit imprimé parallèle à la plaque extérieure isolante, la face avant comprenant au moins une électrode de détection capacitive raccordée à un circuit de détection capacitive et fournissant un signal lors d'une variation de capacité de l'électrode de détection,
- un couvercle recouvrant une face arrière du circuit imprimé et comprenant une ouverture,
- un logement d'une pile bouton situé entre le couvercle et la face arrière, la pile étant insérée dans le logement par l'ouverture, alimentant l'émetteur une fois dans le logement et présentant alors une zone de recouvrement avec l'électrode de détection,
- un comparateur comparant le signal à un seuil pour provoquer l'émission d'un ordre de commande par une unité de commande de l'émetteur.

Il est **caractérisé en ce que** le seuil est supérieur à l'amplitude du signal lors d'une variation de capacité de l'électrode de détection due à un déplacement de la pile dans son logement et/ou due au contact d'un doigt sur la pile à travers l'ouverture.

Le logement peut être délimité par des moyens mécaniques permettant d'obtenir un seuil inférieur à l'amplitude du signal lors d'une variation de capacité de l'électrode de détection due au mouvement ou au contact du doigt sur la plaque isolante.

Les moyens mécaniques peuvent imposer une distance minimum entre la pile et la face avant et/ou peuvent limiter les déplacements de la pile en direction de la face avant et/ou peuvent limiter les déplacements de la pile parallèlement à la face avant, lorsque la pile est dans son logement.

La distance minimum peut être supérieure à 1.5 mm et, de préférence, supérieure à 1.8 mm.

Les déplacements de la pile en direction de la face avant peuvent être limités à 0.2 fois l'épaisseur de la pile ou 0.6 mm et, de préférence, limités à 0.1 fois épaisseur de la pile ou 0.3 mm.

Les déplacements de la pile parallèlement à la face avant peuvent être limités à 0.05 fois le diamètre de la pile ou 1.2 mm et, de préférence, limités à 0.02 fois le diamètre de la pile ou 0.5 mm.

Au moins certains moyens mécaniques peuvent faire partie du couvercle.

L'unité de commande peut comprendre un circuit de temporisation empêchant l'émission d'un ordre de commande tant qu'un délai n'est pas écoulé après un début d'alimentation de l'unité de commande.

L'émetteur domotique peut comprendre un inclinomètre produisant un signal empêchant l'émission d'un ordre de commande tant que l'émetteur est au moins sensiblement orienté selon une direction donnée ou tant que l'émetteur n'est pas au moins sensiblement orienté selon une direction donnée.

L'épaisseur (mesurée entre les surfaces extérieures de la plaque isolante et du couvercle) peut être inférieure à 15 mm, et de préférence inférieure à 10 mm.

L'invention sera mieux comprise à la lecture de la description qui va suivre, donnée uniquement à titre d'exemple et faite en se référant aux dessins annexés sur lesquels :
La figure 1 décrit schématiquement, sous forme de blocs fonctionnels un émetteur selon l'invention.
La figure 2 décrit l'émetteur sous forme d'une coupe dans un plan perpendiculaire au plan principal de l'émetteur.
La figure 3 représente partiellement l'émetteur en vue de dessous.
La figure 4 décrit une étape de réglage d'un seuil de détection dans l'émetteur.
La figure 5 décrit une première procédure de fonctionnement d'un émetteur selon l'invention.
La figure 6 décrit une deuxième procédure de fonctionnement d'un émetteur selon l'invention.

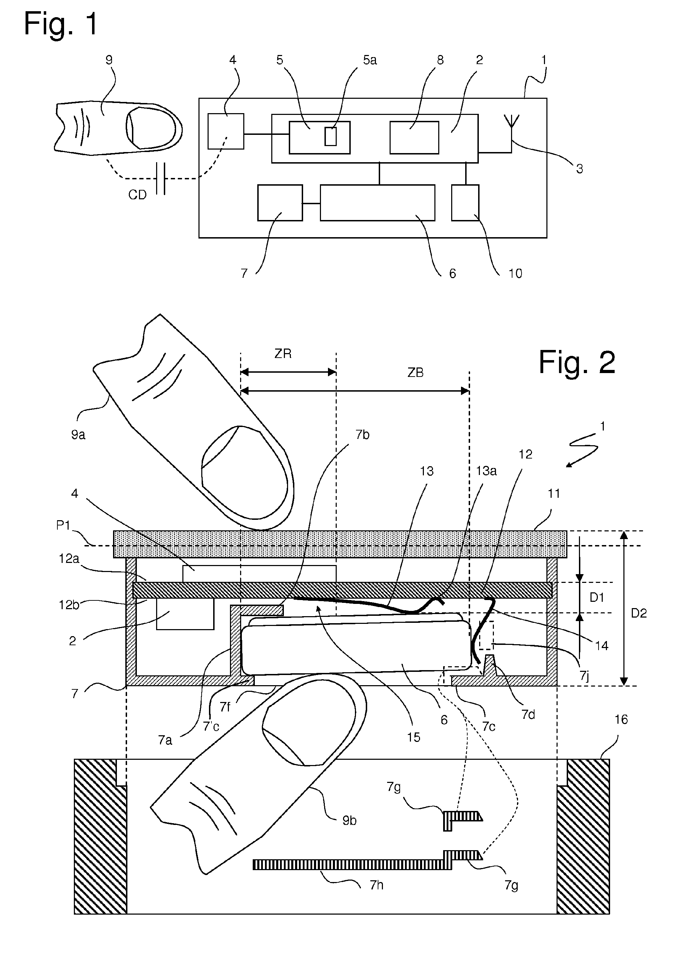

La figure 1 représente schématiquement un émetteur 1 comprenant une unité de commande 2, telle qu'un microcontrôleur apte à émettre une commande par voie radiofréquences représentée par le symbole d'une antenne 3, au moins une électrode de détection capacitive 4 et un circuit de détection capacitive 5, ces éléments étant connus de l'état de la technique. En particulier on désigne ici par électrode de détection capacitive un système en général constitué d'une première électrode de type disque concentrique d'une deuxième électrode de type anneau. Ce système d'électrodes forme un condensateur dans un circuit résonant alimenté à une fréquence donnée par le circuit de détection qui reçoit un signal en retour, par exemple un courant s'il alimente les électrodes en tension. L'approche d'un corps étranger, en l'occurrence le doigt 9 de l'utilisateur, provoque une variation de la capacité vue entre électrodes, donc de la fréquence de résonance donc de l'amplitude du signal reçu par le détecteur. Ce signal (en amplitude ou en variation d'amplitude) est comparé à un seuil 5a et l'unité de commande émet une commande quand le seuil est dépassé du fait de l'ajout d'une capacité de doigt CD.

Selon les variantes de réalisation, l'émission d'une commande correspond donc soit à une valeur donnée de la nouvelle capacité soit à une variation donnée par unité de temps, pour prendre en compte l'aspect dynamique, soit encore à une combinaison des deux.

L'unité de commande est raccordée à une pile primaire plate, de type pile bouton 6.

Préférentiellement, l'émetteur comprend plusieurs électrodes de détection 4 séparées les unes des autres de manière à permettre l'émission de plusieurs commandes différentes selon que le doigt 9 s'approche de l'une ou de l'autre des électrodes. Un cas particulier est celui de trois électrodes alignées, la première servant à définir une commande de montée (ou d'ouverture), la deuxième servant à définir une commande d'arrêt et la troisième servant à définir une commande de descente (ou de fermeture) dans le cas d'un émetteur envoyant des ordres de commande à un actionneur motorisé de store ou de volet roulant.

La figure 2 décrit l'émetteur 1 sous forme d'une coupe dans un plan perpendiculaire à un plan principal de l'émetteur défini comme étant le plan principal d'une plaque extérieure isolante 11 servant de partie visible à l'émetteur une fois celui-ci encastré dans un cadre mural, la plaque extérieure servant à recouvrir l'électronique de l'émetteur. La trace P1 de ce plan principal est représentée sous forme d'un trait pointillé.

La plaque extérieure isolante est rigide, réalisée en verre ou en matière plastique. Elle est de préférence rectangulaire ou carrée et mesure par exemple 5 centimètres sur chaque côté et entre 3 et 5 millimètres en épaisseur. La plaque extérieure peut combiner deux plaques superposées de manière à produire un effet optique particulier depuis l'extérieur. Un premier doigt 9a est représenté en position extérieure, c'est-à-dire dans une position normale d'action sur l'émetteur.

Sous la plaque extérieure est disposé un circuit imprimé double-face 12, parallèle à la plaque extérieure et dont une face avant 12a, tournée vers la plaque extérieure, comprend au moins l'électrode de détection capacitive 4, par exemple sous forme de disque-anneau dont la coupe représente le diamètre extérieur. La face avant 12a peut supporter d'autres composants électroniques de faible épaisseur.

Une face arrière 12b du circuit imprimé comprend les composants électroniques de plus grande épaisseur. L'unité de commande 2 est par exemple logée sur la face arrière. Une zone de logement ZB de diamètre au moins égal au diamètre de la pile bouton 6 est affectée à la mise en place de la pile bouton. Cette zone comprend une première électrode de contact 13 et une deuxième électrode de contact 14, raccordées au circuit imprimé et connectées à l'unité de commande 2, ces électrodes étant destinées à transmettre au circuit imprimé l'énergie électrique de la pile.

Une zone de recouvrement ZR est délimitée par la partie commune des projections orthogonales de la pile bouton et de l'électrode de détection sur un plan parallèle au plan P1.

Un couvercle 7 protège l'arrière du circuit imprimé et assure le maintien mécanique de celui-ci avec la plaque extérieure. Dans le cas d'un point de commande nomade, le couvercle peut assurer une fonction d'étanchéité, au moins vis-à-vis de projections d'eau ou de poussières. Il augmente la solidité de l'émetteur et facilite sa prise en main.

Ce couvercle comprend des moyens mécaniques constitutifs du logement de pile. Le couvercle comprend parmi les moyens mécaniques constitutifs du logement de pile une butée latérale 7a limitant le mouvement latéral de la pile bouton, une languette 7b limitant le déplacement de la pile bouton perpendiculairement au plan principal P1 vers le circuit imprimé, une ou plusieurs extensions 7c, 7'c assurant le blocage de la pile bouton sous l'effet de la poussée de la première électrode de contact 13. La butée latérale peut former un mur destiné à entourer complètement ou partiellement la pile. Les électrodes de contact participent avantageusement à fixer des limites au mouvement de la pile bouton. Dans ce cas, les électrodes font partie du logement de pile.

En particulier la languette 7b et/ou la première électrode 13 (qui vient en blocage contre la face arrière 12b du circuit imprimé lorsqu'on appuie sur la pile, comme représenté sur la figure) assurent une distance minimum D1 entre l'électrode de détection et la pile bouton, de manière à réduire la capacité introduite par la pile bouton. De la même façon, la deuxième électrode 14 est bloquée par une butée 7d du couvercle 7. La première électrode 13 comprend avantageusement une extrémité libre recourbée 13a et joue un rôle équivalent à la languette 7b pour assurer la distance minimum D1.

Préférentiellement, le nombre de languettes du type 7b est augmenté le long de la périphérie de la pile de manière à limiter tout mouvement de basculement de la pile, c'est-à-dire à maintenir la pile parallèle au plan P1 même en cas d'effort sur la pile, notamment en cas d'effort appliqué vers un bord de la pile.

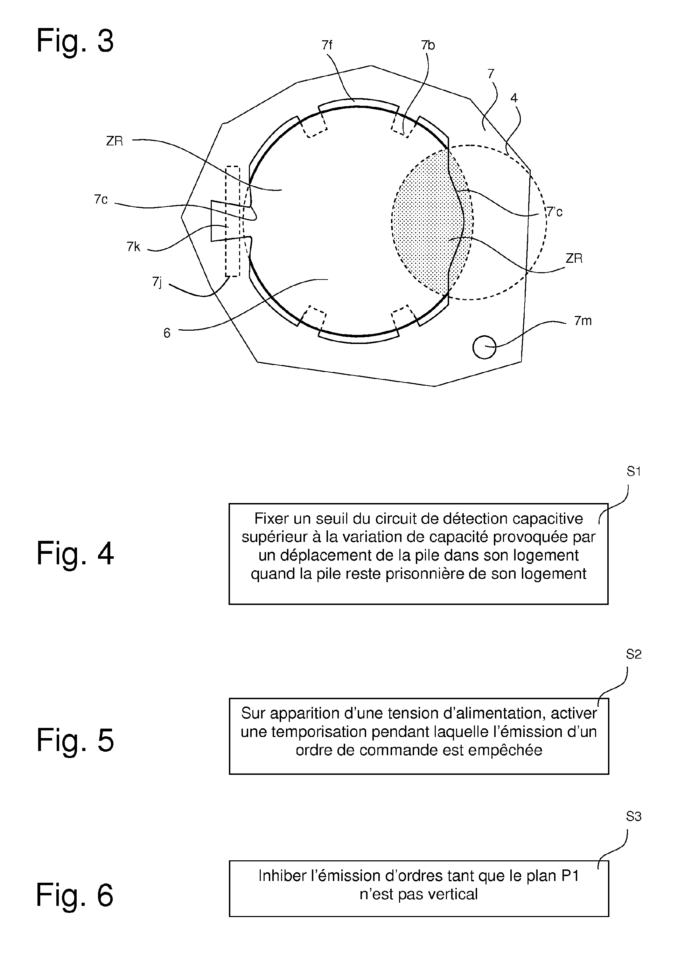

La figure 3 représente partiellement l'émetteur en vue arrière, c'est-à-dire du côté du couvercle. Sur la figure apparaissent quatre languettes du type 7b et trois extensions du type 7c, 7'c bloquant la pile bouton. Un évidement 7k permet d'introduire un outil, par exemple un petit tournevis, pour extraire la pile bouton. La zone de recouvrement ZR est représentée sous forme d'une surface pointillée. Un bouton d'appairage 7m est également représenté.

Ainsi, le mouvement d'introduction de la pile dans l'émetteur reste possible, du fait d'une ouverture 7f de diamètre moyen légèrement supérieur à celui de la pile, l'ouverture étant restreinte par des extensions du type 7c, 7'c, s'étendant vers l'intérieur de l'ouverture. La conception des électrodes de contact et des différents composants du couvercle minimise les mouvements relatifs entre la pile et l'électrode de détection dès lors que la pile est au contact des électrodes de contact. En particulier, ces mouvements relatifs provoqués par le deuxième doigt 9b (notamment dus à l'inclinaison angulaire de la pile lors de l'insertion) sont très faibles dans l'espace 15 situé au droit de la zone de recouvrement. Ainsi, le couvercle 7 et les éléments de positionnement et de maintien de la pile sont agencés de sorte que l'on doive dans un premier temps placer la partie de la pile dans une position quasi-définitive au niveau de la zone de recouvrement, puis basculer la pile sensiblement autour d'un axe dans cette zone avant que la pile vienne en contact avec les électrodes 13 et 14. On dispose donc de préférence le logement de pile de sorte que l'on doive d'abord introduire la pile dans celui-ci au niveau de la zone de recouvrement alors que les électrodes de contact se trouvent à l'opposé dans le logement de pile, ces électrodes n'entrant en contact avec la pile, de préférence, que lorsque la pile est sensiblement en position. Dans le mouvement de basculement mentionné plus haut, la pile pénètre dans le logement du fait de la déformation du logement, notamment lors du déplacement élastique des électrodes ou éventuellement de la déformation des extensions 7c.

Une fois la pile disposée dans le logement, elle est susceptible de se déplacer à l'intérieur des limites fixées par les moyens mécaniques, sous l'effet d'une poussée du deuxième doigt 9b comme représenté.

Dans l'émetteur, on fixe un seuil supérieur à l'amplitude du signal produit lors d'une variation de capacité de l'électrode de détection due à un déplacement de la pile dans son logement et/ou due au contact d'un doigt sur la pile à travers l'ouverture. Ce seuil est tel que le signal produit lors d'une variation de capacité de l'électrode de détection due au mouvement ou au contact du doigt sur la plaque isolante au niveau de l'électrode capacitive est supérieur au seuil.

L'émetteur comprend donc un circuit de détection capacitive 5 muni d'un comparateur à seuil 5a dont le seuil est supérieur à la variation de capacité résultant d'un déplacement de la pile dans son logement, limité par les moyens mécaniques et/ou résultant d'un appui sur la pile. La figure 4 représente, sous forme d'une étape S1, un réglage du seuil. Alternativement, le seuil est fixé par des composants, par exemple un diviseur potentiométrique ou par logiciel dans l'unité de commande.

Le seuil doit néanmoins rester suffisamment faible pour permettre une détection d'usage, c'est-à-dire une détection du doigt dans une position normale d'action de l'émetteur telle que définie précédemment (Le doigt 9a effleurant la plaque transparente 11). Si le seuil 5a ainsi ajusté en fonction d'un déplacement de la pile dans son logement est trop élevé pour permettre cette détection d'usage, alors il convient de modifier le logement de pile, pour diminuer encore les variations de capacité résultant d'une action sur la pile, par exemple en augmentant la distance minimum D1.

Ainsi configuré, l'émetteur est tel que le seuil est inférieur à l'amplitude du signal provoqué par une variation de capacité de l'électrode de détection due au mouvement ou au contact du doigt sur la plaque isolante. L'émetteur est donc apte à fonctionner en usage normal et à ne pas provoquer d'émission intempestive lors d'une manipulation au voisinage du couvercle, par exemple lors d'une opération d'appairage.

Pour obtenir la relation d'ordre adéquate entre :
- signal produit lors d'une variation de capacité de l'électrode de détection due à un déplacement de la pile dans son logement et/ou due au contact d'un doigt sur la pile à travers l'ouverture,
- seuil, et
- signal produit lors d'une variation de capacité de l'électrode de détection due au mouvement ou au contact du doigt sur la plaque isolante au niveau de l'électrode capacitive,
on utilise des caractéristiques du logement de pile.

Notamment, le fait de maintenir une distance minimum, par exemple 0.5 mm plus l'épaisseur du circuit imprimé entre la pile et l'électrode de détection réduit la valeur de la capacité CD, surtout si cette distance est remplie par de l'air ou un matériau à faible constante diélectrique relative (proche de 1). Dans ces circonstances, le seul fait de toucher la pile par le deuxième doigt 9b, sans la déplacer, introduit une variation de capacité inférieure au seuil de détection. De même, un appui sur la pile alors qu'elle est dans son logement introduit une variation de capacité inférieure au seuil de détection. Réciproquement, le seuil de détection doit aussi être fixé pour être supérieur à la variation de capacité provoquée par un mouvement de la pile à l'intérieur de son logement, ce mouvement étant limité par les moyens évoqués plus haut.

Ainsi, les moyens prévus dans le logement n'évitent pas l'apparition d'un signal provoqué par la variation de capacité lors d'une insertion de la pile, mais ils peuvent garantir que ce signal est inférieur au seuil provoquant l'émission de la commande lors d'un mouvement de la pile dans son logement, ou lors d'un contact du doigt avec celle-ci.

Un circuit de temporisation 8 contenu dans l'unité de commande permet de plus d'éviter les émissions intempestives lors d'une insertion de la pile bouton.

Comme représenté sous forme d'une première procédure de fonctionnement S2 sur la figure 5, le circuit de temporisation interdit l'émission d'une commande pendant une durée prédéterminée après l'apparition d'une tension électrique d'alimentation dans l'unité de commande. Ainsi, tous les mouvements de la pile bouton et les appuis avec le premier doigt 9a comme avec le deuxième doigt 9b sont sans effet pendant la durée de temporisation, même s'ils produisent un signal dépassant le seuil.

Une temporisation peut aussi être provoquée par un appui particulier sur le bouton d'appairage 7m, ce qui permet de retirer la pile sans risque d'émission de commandes intempestives.

Bien que le prix du produit s'en trouve renchéri, un inclinomètre 10, pouvant être simplement réalisé avec un micro-contact à bille mobile, est raccordé à l'unité de commande et inhibe l'émission de commandes tant que le plan principal de l'émetteur n'est pas un plan vertical, comme représenté sous forme d'une deuxième procédure de fonctionnement S3 dans la figure 6.

Le circuit de temporisation et l'inclinomètre peuvent être utilisés simultanément, par exemple le micro-contact à bille peut relancer une temporisation d'inhibition chaque fois qu'un déplacement de la bille agit sur le micro-contact et signale un mouvement de l'émetteur.

Le circuit de temporisation est éventuellement constitué par un microcontrôleur de l'unité de commande et un dispositif temporisé de contrôle d'alimentation associé à ce microcontrôleur. La valeur de la temporisation peut aussi comprendre le temps de calibrage nécessaire à l'émetteur pour fixer le niveau moyen de capacité mesurée, à partir duquel sont détectées des variations de capacité.

Avantageusement, le délai apporté par le circuit de temporisation peut être mis à profit pour insérer une cale de verrouillage 7g ou 7g' entre la pile et l'extension 7c. La cale de verrouillage provoque une déformation élastique de la première électrode 13 jusqu'à son blocage par le circuit imprimé.

Dans le cas d'un émetteur nomade, la cale de verrouillage 7g' est comprise dans une trappe 7h qui présente alors l'avantage de complètement fermer le couvercle 7. L'émetteur gagne alors en esthétique et en étanchéité, mais l'épaisseur du produit devient plus importante. La trappe est apte à recouvrir la pile bouton quand elle est disposée dans son logement. De préférence, cette trappe agit sur un moyen de libération 7j d'une électrode de contact, par exemple l'électrode 14. Une position verrouillée de la trappe libère l'électrode de sorte que celle-ci vient en contact avec la pile bouton. Alternativement, la trappe supporte une troisième électrode de contact entrant en contact avec la face arrière de la pile bouton. La deuxième électrode 14 est décalée pour ne jamais entrer en contact direct avec le bord de la pile bouton mais uniquement avec la troisième électrode de contact lorsque la trappe atteint une position verrouillée.

La partie basse de la figure 2 représente un cadre 16 dans lequel l'émetteur peut être encastré. Pour un émetteur de type mural, le cadre est disposé sur un mur vertical. Dans le cas d'un émetteur nomade, le cadre peut être placé horizontalement sur une table ou sur un bureau.

Grâce à l'invention, il est possible d'obtenir un émetteur mural à détection capacitive dont l'épaisseur D2 est inférieure dans certains cas à 10 mm et au moins inférieure à 15 mm avec une pile bouton d'épaisseur 3 mm.

Exception faite des électrodes de contact (et éventuellement de la trappe), tous les moyens mécaniques définissant le logement de pile appartiennent au couvercle, ce qui simplifie la réalisation de l'émetteur.

## Revendications

1. Émetteur domotique (1) de type point de commande et de type sensitif à détection capacitive, comprenant :
- une plaque extérieure isolante (11) sous laquelle est disposée une face avant (12a) d'un circuit imprimé (12) parallèle à la plaque extérieure isolante, la face avant comprenant au moins une électrode de détection capacitive (4) raccordée à un circuit de détection capacitive (5) et fournissant un signal lors d'une variation de capacité de l'électrode de détection,
- un couvercle (7) recouvrant une face arrière (12b) du circuit imprimé et comprenant une ouverture (7f),
- un logement d'une pile bouton (6) situé entre le couvercle et la face arrière, la pile étant insérée dans le logement par l'ouverture, alimentant l'émetteur une fois dans le logement et présentant alors une zone de recouvrement (ZR) avec l'électrode de détection,
- un comparateur comparant le signal à un seuil (5a) pour provoquer l'émission d'un ordre de commande par une unité de commande (2) de l'émetteur,
dans lequel le seuil est supérieur à l'amplitude du signal lors d'une variation de capacité de l'électrode de détection due à un déplacement de la pile dans son logement et/ou due au contact d'un doigt sur la pile à travers l'ouverture.

2. Émetteur domotique selon la revendication 1, **caractérisé en ce que** le logement est délimité par des moyens mécaniques (7a, 7b, 12b, 13a, 14, 7d) permettant d'obtenir un seuil inférieur à l'amplitude du signal lors d'une variation de capacité de l'électrode de détection due au mouvement ou au contact du doigt sur la plaque isolante.

3. Émetteur domotique selon la revendication 1 ou 2, **caractérisé en ce que** les moyens mécaniques imposent une distance minimum (D1) entre la pile et la face avant et/ou limitent les déplacements de la pile en direction de la face avant et/ou limitent les déplacements de la pile parallèlement à la face avant, lorsque la pile est dans son logement.

4. Émetteur domotique selon la revendication 3, **caractérisé en ce que** la distance minimum est supérieure à 1.5 mm et, de préférence, supérieure à 1.8 mm.

5. Émetteur domotique selon la revendication 3 ou 4, **caractérisé en ce que** les déplacements de la pile en direction de la face avant sont limités à 0.2 fois l'épaisseur de la pile ou 0.6 mm et, de préférence, limités à 0.1 fois épaisseur de la pile ou 0.3 mm.

6. Émetteur domotique selon la revendication 3, 4 ou 5, **caractérisé en ce que** les déplacements de la pile parallèlement à la face avant sont limités à 0.05 fois le diamètre de la pile ou 1.2 mm et, de préférence, limités à 0.02 fois le diamètre de la pile ou 0.5 mm.

7. Emetteur domotique selon l'une des revendications précédentes, **caractérisé en ce qu'**au moins certains moyens mécaniques font partie du couvercle.

8. Emetteur domotique selon l'une des revendications précédentes, **caractérisé en ce que** l'unité de commande comprend un circuit de temporisation (8) empêchant l'émission d'un ordre de commande tant qu'un délai n'est pas écoulé après un début d'alimentation de l'unité de commande.

9. Emetteur domotique selon l'une des revendications précédentes, **caractérisé en ce qu'**il comprend un inclinomètre (10), produisant un signal empêchant l'émission d'un ordre de commande tant que l'émetteur est au moins sensiblement orienté selon une direction donnée ou tant que l'émetteur n'est pas au moins sensiblement orienté selon une direction donnée.

10. Émetteur domotique selon l'une des revendications précédentes, **caractérisé en ce que** l'épaisseur (D2) (mesurée entre les surfaces extérieures de la plaque isolante et du couvercle) est inférieure à 15 mm, et de préférence inférieure à 10 mm.

## Patentansprüche

1. Heimsender (1) vom Typ Steuerpunkt und vom Sensortyp für die kapazitive Erkennung, der Folgendes aufweist:
- eine äußere Isolierplatte (11) unter der eine Vorderseite (12a) einer gedruckten Schaltung (12) parallel zur äußeren Isolierplatte angeordnet ist, wobei die Vorderseite mindestens eine Elektrode (4) für die kapazitive Erkennung aufweist, die mit einer Schaltung (5) zur kapazitiven Erkennung verbunden ist und bei einer Schwankung der Kapazität der Elektrode zur Erkennung ein Signal liefert,
- eine Abdeckung (7), die eine Rückseite (12b) der gedruckten Schaltung abdeckt und eine Öffnung (7f) aufweist,
- eine Knopfzellenaufnahme (6), die sich zwischen der Abdeckung und der Rückseite befindet, wobei die Zelle über die Öffnung in die Aufnahme eingesetzt wird, den Sender, wenn sie sich in der Aufnahme befindet, mit Strom versorgt und dann einen Überlagerungsbereich (ZR) mit der Elektrode zur Erkennung aufweist,
- einen Komparator, der das Signal mit einem Schwellenwert (5a) vergleicht, um das Senden eines Steuerbefehls durch eine Steuereinheit (2) des Senders zu bewirken,
wobei der Schwellenwert höher ist als die Amplitude des Signals bei einer Schwankung der Kapazität der Elektrode zur Erkennung aufgrund einer Verschiebung der Zelle in ihrer Aufnahme und/oder aufgrund der Berührung eines Fingers auf der Zelle durch die Öffnung.

2. Heimsender nach Anspruch 1, **dadurch gekennzeichnet, dass** die Aufnahme durch mechanische Mittel (7a, 7b, 12b, 13a, 14, 7d) begrenzt wird, die das Erhalten eines Schwellenwerts ermöglichen, der niedriger als die Amplitude des Signals bei einer Schwankung der Kapazität der Elektrode zur Erkennung aufgrund der Bewegung oder der Berührung des Fingers auf der Isolierplatte ist.

3. Heimsender nach Anspruch 1 oder 2, **dadurch gekennzeichnet, dass** die mechanischen Mittel einen Mindestabstand (D1) zwischen der Zelle und der Vorderseite vorgeben und/oder die Verschiebungen der Zelle in Richtung der Vorderseite begrenzen und/oder die Verschiebungen der Zelle parallel zur Vorderseite begrenzen, wenn die Zelle sich in ihrer Aufnahme befindet.

4. Heimsender nach Anspruch 3, **dadurch gekennzeichnet, dass** der Mindestabstand größer als 1.5 mm und vorzugsweise größer als 1.8 mm ist.

5. Heimsender nach Anspruch 3 oder 4, **dadurch gekennzeichnet, dass** die Verschiebungen der Zelle in Richtung der Vorderseite auf 0.2 Mal die Dicke der Zelle oder 0.6 mm begrenzt und vorzugsweise auf 0.1 Mal die Dicke der Zelle oder 0.3 mm begrenzt sind.

6. Heimsender nach Anspruch 3, 4 oder 5, **dadurch gekennzeichnet, dass** die Verschiebungen der Zelle parallel zur Vorderseite auf 0.05 Mal der Durchmesser der Zelle oder 1.2 mm begrenzt sind und vorzugsweise auf 0.02 Mal der Durchmesser der Zelle oder 0.5 mm begrenzt sind.

7. Heimsender nach einem der vorhergehenden Ansprüche, **dadurch gekennzeichnet, dass** mindestens bestimmte mechanische Mittel Teil der Abdeckung sind.

8. Heimsender nach einem der vorhergehenden Ansprüche, **dadurch gekennzeichnet, dass** die Steuereinheit eine Verzögerungsschaltung (8) aufweist, die das Senden eines Steuerbefehls verhindert, solange eine Frist nach einem Beginn der Stromversorgung der Steuereinheit nicht verstrichen ist.

9. Heimsender nach einem der vorhergehenden Ansprüche, **dadurch gekennzeichnet**, das er einen Neigungsmesser (10) aufweist, der ein Signal erzeugt, das das Senden eines Steuerbefehls verhindert, solange der Sender mindestens im Wesentlichen entlang einer gegebenen Richtung ausgerichtet ist oder solange der Sender nicht mindestens im Wesentlichen entlang einer gegebenen Richtung ausgerichtet ist.

10. Heimsender nach einem der vorhergehenden Ansprüche, **dadurch gekennzeichnet, dass** die Dicke (D2) (gemessen zwischen den Außenflächen der Isolierplatte und der Abdeckung) kleiner als 15 mm und vorzugsweise kleiner als 10 mm ist.

## Claims

1. Home automation transmitter (1) of control point type and of sensitive type with capacitive detection, comprising:
- an insulating outer plate (11) under which is positioned a front face (12a) of a printed circuit (12) parallel to the insulating outer plate, the front face comprising at least one capacitive detection electrode (4) connected to a capacitive detection circuit (5) and supplying a signal upon a variation of capacitance of the detection electrode,
- a cover (7) covering a rear face (12b) of the printed circuit and comprising an opening (7f),
- a housing for a button cell battery (6) situated between the cover and the rear face, the cell battery being inserted into the housing through the opening, powering the transmitter once in the housing and then having an area of overlap (ZR) with the detection electrode,
- a comparator comparing the signal to a threshold (5a) to provoke the transmission of a control command by a control unit (2) of the transmitter,
in which the threshold is greater than the amplitude of the signal upon a variation of capacitance of the detection electrode due to a displacement of the cell battery in its housing and/or due to the contact of a finger on the cell battery through the opening.

2. Home automation transmitter according to Claim 1, **characterized in that** the housing is delimited by mechanical means (7a, 7b, 12b, 13a, 14, 7d) making it possible to obtain a threshold less than the amplitude of the signal upon a variation of capacitance of the detection electrode due to the movement or to the contact of the finger on the insulating plate.

3. Home automation transmitter according to Claim 1 or 2, **characterized in that** the mechanical means impose a minimum distance (D1) between the cell battery and the front face and/or limit the displacements of the cell battery towards the front face and/or limit the displacements of the cell battery parallel to the front face when the cell battery is in its housing.

4. Home automation transmitter according to Claim 3, **characterized in that** the minimum distance is greater than 1.5 mm and, preferably, greater than 1.8 mm.

5. Home automation transmitter according to Claim 3 or 4, **characterized in that** the displacements of the cell battery towards the front face are limited to 0.2 times the thickness of the cell battery or 0.6 mm and, preferably, limited to 0.1 times the thickness of the cell battery or 0.3 mm.

6. Home automation transmitter according to Claim 3, 4 or 5, **characterized in that** the displacements of the cell battery parallel to the front face are limited to 0.05 times the diameter of the cell battery or 1.2 mm and, preferably, limited to 0.02 times the diameter of the cell battery or 0.5 mm.

7. Home automation transmitter according to one of the preceding claims, **characterized in that** at least certain mechanical means form part of the cover.

8. Home automation transmitter according to one of the preceding claims, **characterized in that** the control unit comprises a timer circuit (8) preventing the transmission of a control command until a delay has elapsed after the start of power supply to the control unit.

9. Home automation transmitter according to one of the preceding claims, **characterized in that** it comprises an inclinometer (10), producing a signal preventing the transmission of a control command as long as the transmitter is at least substantially oriented in a given direction or as long as the transmitter is not at least substantially oriented in a given direction.

10. Home automation transmitter according to one of the preceding claims, **characterized in that** the thickness (D2) (measured between the outer surfaces of the insulating plate and of the cover) is less than 15 mm and preferably less than 10 mm.
